# EUROPEAN PATENT APPLICATION

(11) **EP 3 866 198 A1**
(43) Date of publication of application: **18.08.2021**
(21) Application number: 20157604.8
(22) Date of filing: 17.02.2020
(51) Int. Cl.: H01L 27/082, H01L 29/732, H01L 29/737, H01L 29/08

(54) **SEMICONDUCTOR DEVICE**

(71) Applicant: NXP B.V., 5656 AG Eindhoven (NL)
(72) Inventor: Magnee, Petrus Hubertus Cornelis, Redhill, Surrey RH1 1QZ (GB); Acar, Mustafa, Redhill, Surrey RH1 1QZ (GB); Leenaerts, Dominicus Martinus Wilhelmus, Redhill, Surrey RH1 1QZ (GB)
(74) Representative: Miles, John Richard

(57) **Abstract**

A semiconductor device is described including a substrate (302) and a plurality of layers. The semiconductor device includes a cascode arrangement of a first bipolar transistor (162) and a second bipolar transistor (164). A first-bipolar-transistor-collector of the first bipolar transistor and a second-bipolar-transistor-emitter of the second bipolar transistor are at least partially located in a common region (310) in the same layer of the semiconductor device.

## Description

This disclosure relates to a semiconductor device including a cascode arrangement of a first bipolar transistor and a second bipolar transistor.

### BACKGROUND

Radio-frequency (RF) amplifier circuits are often implemented using BiCMOS processes as, although CMOS based technologies may be used to implement RF amplifiers, bipolar transistors may provide more optimal performance for certain power levels and operation frequencies. These bipolar transistors are often implemented in several sections with finger-like transistor shapes. The bipolar transistors may be implemented as heterojunction bipolar transistors (HBT) for example using Silicon-Germanium (Si-Ge) BiCMOS processes. HBTs implemented using Si-Ge BiCMOS processes may have good performance characteristics in higher frequency ranges above 20 GHz which are used for example in 5G mobile communications applications. RF amplifiers implemented using BiCMOS processes may be used for example as power amplifiers which receive a signal for transmission from a transceiver and drive an antenna or low noise amplifiers which receive a signal from an antenna and output the received signal to the transceiver.

RF amplifiers implemented using bipolar transistors may include a cascode stage having a cascode arrangement of a common-emitter (CE) stage including one or more bipolar transistors in a common-emitter configuration and a common-base (CB) stage including one or more bipolar transistors in a common-base configuration. A common-emitter/common-base cascode stage is a frequently used amplifier stage, both in Power Amplifier (PA) and in Low Noise Amplifier (LNA) circuits, offering high gain, high bandwidth, high slew rate, high stability, and high input impedance.

### SUMMARY

Various aspects of the disclosure are defined in the accompanying claims. In a first aspect there is provided a semiconductor device comprising a substrate, a plurality of layers located on or in the substrate and a lateral cascode arrangement of a first bipolar transistor and a second bipolar transistor, wherein the first bipolar transistor comprises a first-bipolar-transistor-collector, the second bipolar transistor comprises a second-bipolar-transistor-emitter, and wherein the first-bipolar-transistor-collector and the second-bipolar-transistor-emitter are at least partially located in a common region in one layer of said plurality of layers.

In one or more example embodiments, the first bipolar transistor further may comprise a first-bipolar-transistor-base located above the first-bipolar-transistor-collector and a first-bipolar-transistor-emitter located above the first-bipolar-transistor-base and the second bipolar transistor comprises a second-bipolar-transistor-base located above the second-bipolar-transistor-emitter and a second-bipolar-transistor-collector located above the second-bipolar-transistor-base.

In one or more example embodiments, the common region may comprise a buried N type layer.

In one or more example embodiments, the first and second bipolar transistors may be NPN transistors.

In one or more example embodiments, the common region the common region may be located between two trenches.

In one or more example embodiments, the semiconductor device may comprise a common emitter stage comprising the first bipolar transistor and a common base stage comprising the second bipolar transistor.

In one or more example embodiments, the second-bipolar-transistor-collector may include a portion extending laterally past an edge of the second-bipolar-transistor-base.

In one or more example embodiments, the second-bipolar-transistor-collector may comprise a collector gate.

In one or more example embodiments, the first bipolar transistor emitter and second bipolar transistor emitter further comprise at least one emitter finger.

In one or more example embodiments, the first bipolar transistor may comprise at least one section located above the common region and the second bipolar transistor may comprise at least two sections located above the common region and wherein the each section of the at least one first bipolar transistor section is arranged alternately with each section of the at least two second bipolar transistor sections.

In one or more example embodiments, the semiconductor device may further comprise an input coupled to the first bipolar transistor base, an output coupled to the second bipolar transistor collector, a supply rail coupled to the second bipolar transistor collector, a ground rail coupled to the first bipolar transistor emitter, and a second bipolar transistor base is coupled to a bias voltage rail.

In one or more example embodiments, the first bipolar transistor base and the second bipolar transistor base may be located in the same layer.

In one or more example embodiments, the first bipolar transistor emitter and the second bipolar transistor collector are at least partially located in the same layer.

In one or more example embodiments, the semiconductor device may be a silicon-germanium BiCMOS device.

Embodiments of the semiconductor device may be included in an RF amplifier.

In a second aspect there is provided a semiconductor device having a plurality of layers and comprising a substrate, and a cascode arrangement of a first bipolar transistor in a common emitter configuration and a second bipolar transistor in a common-base configuration, wherein a first-bipolar-transistor-collector and a second-bipolar-transistor-emitter are at least partially located in a common region of the semiconductor device and wherein a first-bipolar-transistor-base is located in the same layer as the second-bipolar-transistor-base.

### BRIEF DESCRIPTION OF THE DRAWINGS

In the figures and description like reference numerals refer to like features. Embodiments are now described in detail, by way of example only, illustrated by the accompanying drawings in which:
Figure 1 Shows a circuit diagram of a typical RF low noise amplifier.
Figure 2 Shows a circuit diagram of a cascode stage for an RF amplifier using NPN bipolar transistors.
Figure 3 Show a cross-section of a typical NPN HBT bipolar transistor implemented using a Si-Ge BiCMOS process.
Figure 4A illustrates a cross-section of a typical implementation of the cascode stage of figure 2 using a Si-Ge BiCMOS process.
Figure 4B illustrates the plan view of the cascode stage implementation of figure 4A.
Figure 5A illustrates a cross-section of an implementation of the cascode stage of figure 2 using a Si-Ge BiCMOS process according to an embodiment.
Figure 5B illustrates the plan view of the cascode stage implementation of figure 5A according to an embodiment.
Figure 6A illustrates a cross section of an implementation of the cascode stage of figure 2 using a Si-Ge BiCMOS process according to an embodiment.
Figure 6B illustrates the plan view of the cascode stage implementation of figure 6A according to an embodiment.
Figure 7A illustrates a cross section of an implementation of the cascode stage of figure 2 using a Si-Ge BiCMOS process according to an embodiment.
Figure 7B illustrates the plan view of the cascode stage implementation of figure 7A according to an embodiment.

### DETAILED DESCRIPTION

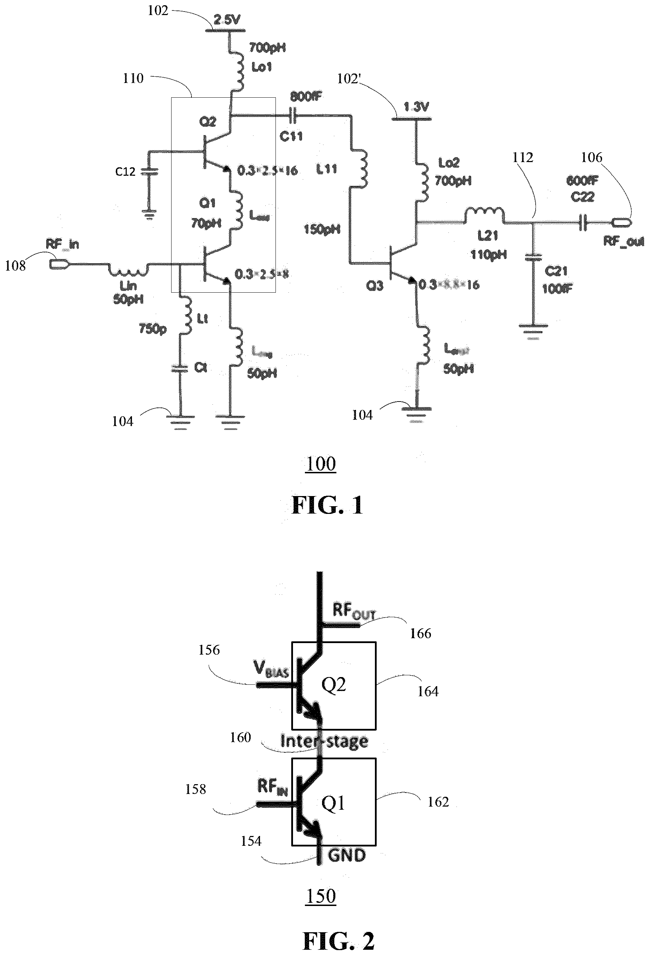

Figure 1 shows a circuit diagram of a typical RF low noise amplifier (LNA) 100 implemented using NPN bipolar transistors. LNA 100 has a cascode input stage 110 including a common emitter (CE) NPN transistor Q1 and a common base (CB) transistor Q2. The low noise amplifier 100 has a second amplifier stage including a NPN transistor Q3 configured as a common emitter transistor. An RF input 108 is connected in series via input inductor Lin to the base of common emitter transistor Q1. A series arrangement of a tank inductor Lt and a tank capacitor Ct is connected between the base of the common emitter transistor Q1 and ground 104. The emitter of common emitter transistor Q1 is connected to ground 104 via the Q1 emitter degeneration inductor L_{deg}. The collector of the common emitter transistor Q1 is connected to the emitter of the common base transistor Q2 via inter-stage matching inductor L_{MID}.

The base of the common base transistor Q2 is connected to ground 104 via capacitor C12. The base of the common base transistor Q2 is connected to a bias circuit (not shown). The collector of common base transistor Q2 is connected to a first stage supply rail 102 via first stage output inductor Lo1. An output matching network including a series arrangement of a first stage matching capacitor C11 and a first stage matching inductor L11 is connected between the collector of the common base transistor Q2 and the base of the second stage common emitter transistor Q3. The emitter of the second stage common emitter transistor Q3 is connected to ground 104 via the Q3 emitter degeneration inductor L_{deg2}. The collector of the second stage common emitter transistor Q3 is connected to the second stage supply rail 102' via the second stage output inductor Lo2. The collector of the second stage common emitter transistor Q3 is connected to the RF output 106 via the second stage output matching network. The second stage output matching network includes a series arrangement of a matching network inductor L21 and a matching network capacitor C22 between the collector of the second stage common emitter transistor Q3 and the RF output 106. The second stage output matching network includes a second matching network capacitor C21 connected between the common node 112 of the matching network inductor L21 and capacitor C22 and ground 104.

The low noise amplifier 100 receives an RF signal on the RF input 108 which goes to the base of the common emitter transistor Q1. The output of the cascode stage 110 is at the collector of the common base transistor Q2 which then goes to the base of the common emitter transistor Q3 of the second stage. The output of the second stage is at the collector of the common emitter transistor Q3. The signal then goes to the RF output 106 of the low noise amplifier 100. The low noise amplifier 100 requires an inductor L_{MID} which needs to be added to have a proper impedance match between the collector of the common emitter transistor Q1 and the emitter of the common base transistor Q2. This inductor L_{MID} may create losses in the low noise amplifier 100 and also require additional area for implementation.

Figure 2 illustrates the circuit diagram of a cascode 150 for an RF amplifier which may be implemented by the various examples and embodiments described herein. The common emitter stage 162 may include a first bipolar NPN transistor Q 1 having a first-bipolar-transistor-emitter connected to a ground rail 154, a first-bipolar-transistor-base connected to an RF input 158 and a first-bipolar-transistor-collector connected to the inter-stage connection 160. The common base stage 164 may include a second NPN bipolar transistor Q2 having a second-bipolar-transistor-emitter connected to the inter-stage connection 160, a second-bipolar-transistor-base operably connected to a bias voltage supply 156, and a second-bipolar-transistor-collector connected to an RF output 166. The connection from the collector of the common base transistor Q2 to the supply voltage via an inductor is not shown.

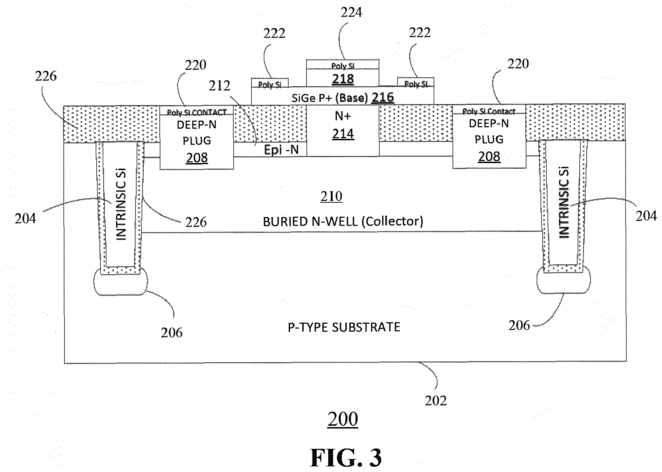

Figure 3 schematically illustrates a cross-section of a vertical NPN HBT transistor 200 known in the art implemented using a silicon germanium (SiGe) BiCMOS process. The transistor 200 may be particularly suitable for high frequency RF applications. The transistor 200 includes a number of layers formed on and in a substrate 202. It will be appreciated that transistor 200 may be formed using standard front-end of the line (FEOL) processing techniques.

The HBT transistor 200 may include trenches 204 formed in the substrate 202 from intrinsic and P-type stopper regions 206 may be formed at the bottom of the trenches 204. The transistor 200 may include a buried N-well region 210 formed in the substrate and between the trenches 204. An epitaxial N-type layer 212 may be formed between the surface of the substrate and the buried N-well 210. Deep-N plugs 208 may be formed which extend from above the major surface of the substrate 202 down to within the buried N-well 210. An N+ region 214 may be formed which extends from above the surface of the substrate 202 to the buried N-well 210. The term N+ is used herein has the usual meaning of an N type semiconductor region with relatively high dopant concentration. The Deep-N plugs 208, N+ region 214, the buried N-well 210 and the epitaxial region 212 may form the collector of the NPN transistor 200. A base region 216 is formed above the N+ region 214 from a layer of silicon germanium. An N-type emitter 218 is formed above the base 216. Collector contacts 220 are formed on the Deep-N plugs 208. Base contacts 222 are formed on the base region 216. Emitter contact 224 is formed on the emitter region 218. Collector contacts 220, base contacts 222, emitter contacts 224 may be formed from polysilicon. The regions 226 indicate areas of dielectric material, however it will be appreciated that dielectric material will also be present in other layers but this is not shown explicitly in figure 3. It will be appreciated that transistor 200 may be formed using standard front-end of the line (FEOL) processing techniques.

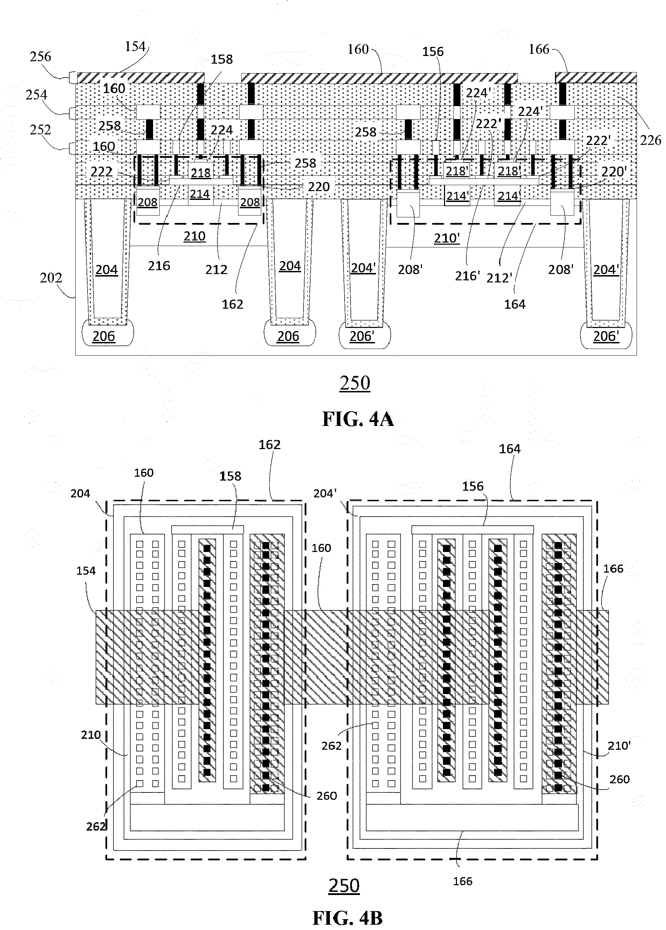

Figure 4A Shows a semiconductor device 250 which implements the cascode stage 150 of figure 2 using HBT NPN transistors similar to transistor 200. Figure 4B Illustrates the plan view of the semiconductor device 250.

The common emitter stage transistor 162 has a collector formed by the buried N well 210, the deep N plug regions 208 the epitaxial region 212 and the N plus region 214 as described previously for figure 3. The common emitter stage transistor 162 has a base 216 formed above the collector. The common emitter stage transistor 162 has an emitter region 218 formed above the base 216. Trenches 204 and P-well stoppers 206 isolate the transistor 162 from the common base transistor 164. Collector contacts 220 are formed on the deep N plugs 208. Base contacts 222 are formed on the base region 216. Emitter contacts 224, are formed on the emitter region 218.

The common base stage transistor 164 has a collector formed by the buried N well 210', the deep N plug regions 208' the epitaxial region 212' and the N plus region 214' similarly to as described previously for transistor 200 illustrated in figure 3. The common base stage transistor 164 has a base 216' formed above the collector. The common base stage transistor 164 has emitter regions 218' formed above the base 216'. Trenches 204' and P-well stoppers 206' isolate the common base transistor 164 from the common emitter transistor 162. Collector contacts 220' are formed on the deep N plugs 208'. Base contacts 222' are formed on the base region 216'. Emitter contacts 224, are formed on the emitter region 218'.

The common base stage transistor 164 and the common emitter transistor 162 are arranged laterally along a horizontal axis. In this disclosure the horizontal axis refers to an axis parallel to a major surface of the substrate 202.

The respective collector regions 214 and 214' are formed on the same layer of the semiconductor device 250. The respective base regions 216 and 216' are formed on the same layer of the semiconductor device 250. The respective emitter regions 218 and 218' are formed on the same layer of the semiconductor device 250.

The semiconductor device 250 has three metal layers respectively 252,254, and 256 which are separated by layers containing dielectric material 226. Vias 258 are used to connect between the different metal layers and to connect the first metal layer 252 to the contacts 220,222,224 of the common emitter transistor 162 and contacts 220',222',224' of the common base transistor 164.

Turning now to figure 4B, the ground rail 154 is connected by the third layer metal 256 to the emitter contact 224 via contacts 260 down through the second metal layer 254 and the first metal layer 252. Contacts 262 illustrate either contacts between the second metal layer 254 and the first metal layer 252 or the first metal layer 254 and the transistor contacts. The common emitter transistor 162 of semiconductor device 250 as illustrated shows a single emitter finger. The common base transistor 164 of semiconductor device 250 as illustrated shows two emitter fingers.

The RF input 158 connects to the base of the common emitter transistor 162. The inter-stage connection 160 is shown as a straight metal connection on the third metal layer 256 which implements the inductor L_{MID}. RF output 166 as shown is implemented on the third metal layer 256 and connects to the collector contact 220' of the common base transistor 164 using vias 258 down through the second metal layer 254 and the first metal layer 252. This inductor L_{MID} may create losses in the cascode and also requires additional area for implementation.

The semiconductor device 200 as shown has six pin connections which are connected via the metal layers 252,254,256 denoted as common-emitter base (CEB), common-emitter emitter (CEE), common-emitter collector (CEC), common-base base (CBB), common-base emitter (CBE), common base collector (CBC).

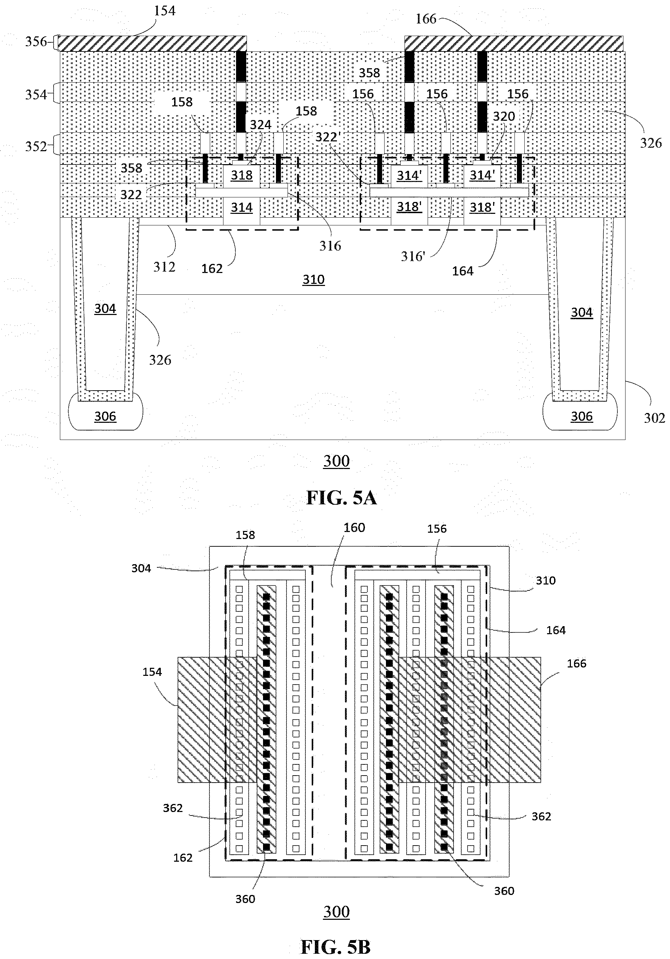

Figure 5A shows a semiconductor device 300 which implements the cascode stage 150 of figure 2 according to an embodiment. Figure 5B illustrates the plan view of the semiconductor device 300.

The semiconductor device 300 includes a number of layers which may be formed on or in a substrate 302. Semiconductor device 300 may include a buried N-well region 310 formed in the substrate and between trenches 304. P-well stopper regions 306 may be formed beneath the trenches 304. An epitaxial N-type layer 312 may be formed above the buried N-well 310. N+ regions 314, 318' may be formed within the same layer and may extend from above the surface of the substrate 302 to the buried N-well 310. The N+ region 314, part of the buried N-well 310 and part of the epitaxial region 312 may form the collector of the common-emitter NPN transistor 164. The N+ region 318', part of the buried N-well 310 and part of the epitaxial region 312 may form the emitter of the common-base NPN transistor 162.

The silicon germanium base regions 316, 316' are formed above the N+ regions 314, 318'. An N-type emitter 318 is formed above the base 316. An N-type collector 314' is formed above the base 316'. Collector contacts 320 are formed on N+ regions 314' . Base contacts 322, 322' are formed on the base region 316. Emitter contact 324 is formed on the emitter region 318. The regions 326 indicate areas of dielectric material.

The respective collector regions for common emitter stage 162 and emitter regions 318' for common base stage 164 may be formed on the same layer of the semiconductor device 300. The respective base regions 316 and 316' may be formed on the same layer of the semiconductor device 300. The emitter region 318 for common emitter stage 162 and collector region 314' for the common base stage 164 are formed on the same layer of the semiconductor device 300. The first bipolar transistor Q1 of the common emitter stage 162 and the second bipolar transistor Q2 of the common base stage 164 may be located in the same horizontal plane.

The semiconductor device 300 has three metal layers respectively 352, 354, and 356 which are separated by layers containing dielectric material 326. Vias 358 are used to connect between the different metal layers and to connect the first metal layer 352 to the contacts 322,324 of the common emitter transistor 162 and contacts 320, 322' of the common emitter transistor 164.

Turning now to figure 5B, the ground rail 154 is connected by the third layer metal 356 to the emitter contact 324 via contacts 360 down through the second metal layer 354 and the first metal layer 352. Contacts 362 illustrate either contacts between the second metal layer 354 and the first metal layer 352 or the first metal layer 354 and the active area contacts. The common emitter transistor 162 of semiconductor device 300 as illustrated shows a single emitter finger. In other examples common emitter stages may have transistors with more emitter fingers. The transistors may be implemented in sections containing one or more emitter finger. The common base transistor 164 of semiconductor device 300 as illustrated shows a single section with two emitter fingers.

The RF input 158 connects to the base of the common emitter transistor 162. RF output 166 as shown is implemented on the third metal layer 356 and connects to the collector contact 320 of the common base transistor 164 using vias 358 down through the second metal layer 354 and the first metal layer 352. The inter-stage connection 160 is effectively formed in the common region of the buried-N layer 310

The inventors of the present disclosure have appreciated that in a modern, high-speed, SiGe BiCMOS process, the collector-base profile is as steep as the emitter-base profile. Consequently the transistors formed by such a process can be configured either with the emitter or collector located at the top. When a device is configured in an "inverse mode" (collector on top) the performance of the device may be similar. By using an inverse-mode transistor for the CB transistor 164, the emitter may be at least partially created in the same device layer, for example the buried N-layer 310, as the collector of the CE transistor 162. Hence, instead of making the connection between both transistors 162,164 via the back-end interconnect, the connection can be made on a common region, in this case a shared buried-N island 310, thereby creating a single integrated cascode device 300. This semiconductor device 300 has 4 pins, CEE, CEB, CBB and CBC, missing the CEC and CBE from the conventional implementation of the semiconductor device 250.

This semiconductor device 300 may have a smaller foot-print than semiconductor device 250 requiring reduced silicon area to implement. The semiconductor device 300 may have reduced inter-stage loss, due to reduced connection resistance because no metal interconnect is required and no contact/Deep-N plug is required. The semiconductor device 300 may further have reduced parasitic substrate capacitance but requires no additional processing compared to known techniques. Further the semiconductor device 300 does not need a Deep-N plug, to connect to the buried-N 310. In some examples the buried-N region 310 may also be omitted and the epilayer 312 used as a common region to form the interconnection.

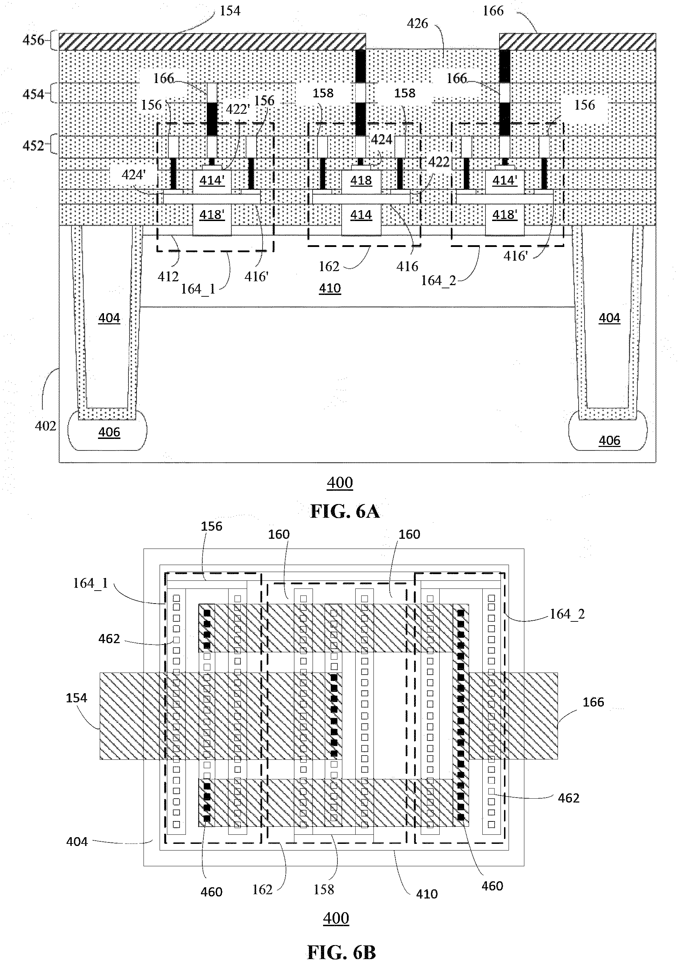

The semiconductor device 300 may be used for a relatively small device, consisting of only a few emitter-fingers. An arrangement for a larger semiconductor device 400 is shown in cross-section in figure 6A and plan view in figure 6B.

Figure 6A shows a cross-section of the semiconductor device 400 according to an embodiment including a number of layers formed on and in a substrate 402. Semiconductor device 400 may include a buried N-well region 410 formed in the substrate and between trenches 404. P-well stopper regions 406 may be formed beneath the trenches 404. An epitaxial N-type layer 412 may be formed above the buried N-well 410. N+ regions 414, 418'may be formed within the same layer and may extend from above the surface of the substrate 402 to the buried N-well 410. The N+ region 414, part of the buried N-well 410 and part of the epitaxial region 412 may form the collector of the common-emitter NPN transistor 162. The N+ region 418', part of the buried N-well 410 and part of the epitaxial region 412 may form the emitter of the common-base NPN transistor 164 which for semiconductor device 400 is implemented as two sections 164_1, 164_2.

The silicon germanium base regions 416, 416' are formed above the N+ regions 414, 418'. An N-type emitter 418 is formed above the base 416. An N-type collector 414' is formed above the base 416'. Collector contacts 420 are formed on N+ regions 414' . Base contacts 422, 422' are formed on the base region 416. Emitter contact 424 is formed on the emitter region 418. The regions 426 indicate areas of dielectric material.

The respective collector regions for common emitter stage 162 and emitter regions 418' for common base stage 164 may be formed on the same layer of the semiconductor device 400. The respective base regions 416 and 416' may be formed on the same layer of the semiconductor device 400. The emitter region 418 for common emitter stage 162 and collector region 414' for the common base stage 164 are formed on the same layer of the semiconductor device 400.

The semiconductor device 400 has three metal layers respectively 452, 454, and 456 which are separated by layers containing dielectric material 426. Vias 458 are used to connect between the different metal layers and to connect the first metal layer 452 to the contacts 422,424 of the common emitter transistor 162 and contacts 420, 422' of the common emitter transistor 164.

Turning now to figure 6B, the ground rail 154 is connected by the third layer metal 456 to the emitter contact 424 via contacts 460 down through the second metal layer 454 and the first metal layer 452. Contacts 462 illustrate either contacts between the second metal layer 454 and the first metal layer 452 or the first metal layer 454 and the active area contacts. The common emitter transistor 162 of semiconductor device 400 as illustrated shows a single emitter finger. In other examples common emitter stages may have transistors with more emitter fingers. The transistors may be implemented in sections containing one or more emitter finger. The common base transistor 164 of semiconductor device 400 as illustrated is implemented in two sections 164_1, 164_2 each section having one emitter finger.

The RF input 158 connects to the base of the common emitter transistor 162. RF output 166 as shown is implemented on the third metal layer 456 and connects to the collector contact 420 of the common base transistor 164 using vias 458 down through the second metal layer 454 and the first metal layer 452. The inter-stage connection 160 is effectively formed in the common region of the buried-N layer 410.

The semiconductor device 400 has a common emitter stage 162 with a single common emitter section a common base stage 164 with two common base sections 164_1, 164_2 on top of the same shared buried-N layer 410. In other examples the common emitter stage may have multiple sections alternating with multiple common base sections depending on the size of the device required. The size ratio between CE transistor 162 and CB transistor 164 may be modified by for example having different section sizes, varying the number of emitter-fingers per section, or varying the length of the emitter-fingers independently for the CE transistor 162 and the CB transistor 164.

This semiconductor device 400 may have a smaller foot-print than semiconductor device 250 requiring reduced silicon area to implement. The semiconductor device 400 may have reduced inter-stage loss, due to reduced connection resistance because no metal interconnect is required and no contact/Deep-N plug is required. The semiconductor device 400 may further have reduced parasitic substrate capacitance but requires no additional processing compared to known techniques.

In semiconductor devices 300,400 the emitter-base junction of the common-base transistor 164 may have a reverse breakdown voltage of the normal mode emitter-base junction which is usually significantly lower than that of the collector-base diode. For higher power devices the common base transistor 162 of the semiconductor devices 300,400 may be further adapted using techniques described for example in European Patent 2784822, US patent 9240468 B2 which may require some additional processing steps.

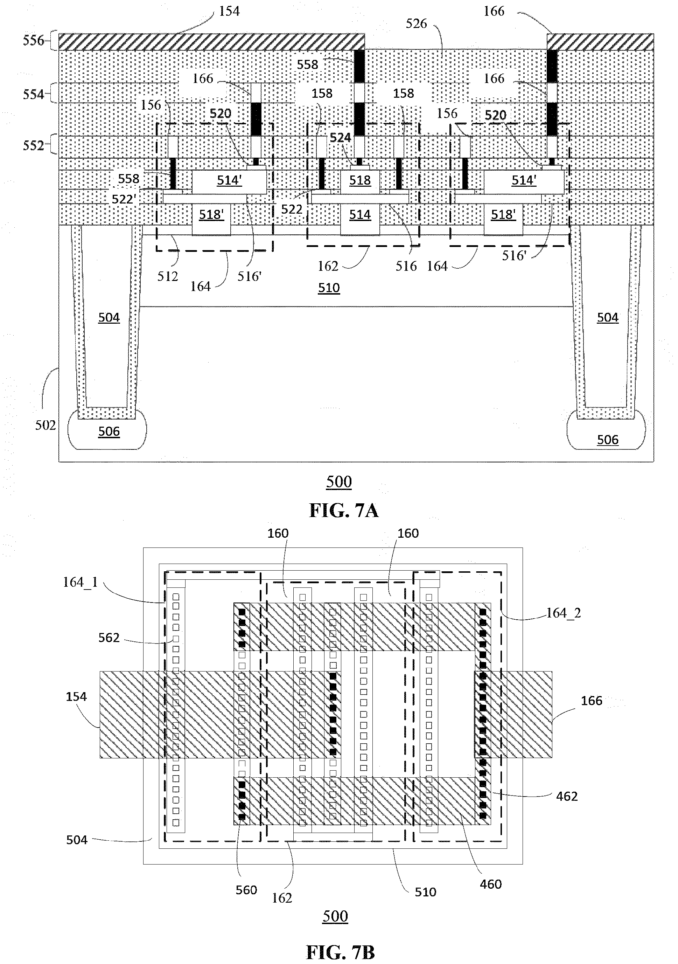

An embodiment of a semiconductor device including one of these techniques is shown in figures 7A and 7B.

Figure 7A shows a cross-section of the semiconductor device 500 according to an embodiment including a number of layers formed on and in a substrate 502. Semiconductor device 500 may include a buried N-well region 510 formed in the substrate and between trenches 504. P-well stopper regions 506 may be formed beneath the trenches 504. An epitaxial N-type layer 512 may be formed above the buried N-well 510. N+ regions 514, 518' may be formed within the same layer and may extend from above the surface of the substrate 502 to the buried N-well 510. The N+ region 514, part of the buried N-well 510 and part of the epitaxial region 512 may form the collector of the common-emitter NPN transistor 162. The N+ region 518', part of the buried N-well 510 and part of the epitaxial region 512 may form the emitter of the common-base NPN transistor 164 which in semiconductor device 500 is implemented as two sections 164_1, 164_2.

The silicon germanium base regions 516, 516' are formed above the N+ regions 514, 518'. An N-type emitter 518 is formed above the base 516. An N-type collector 514' is formed above the base 516'. The collector 514' extends laterally beyond the base. Collector contacts 520 are formed on N+ regions 514' . Base contacts 522, 522' are formed on the base regions 516, 516'. Emitter contact 524 is formed on the emitter region 518. The regions 526 indicate areas of dielectric material.

The respective collector regions for common emitter stage 162 and emitter regions 518' for common base stage 164 may be formed on the same layer of the semiconductor device 500. The respective base regions 516 and 516' may be formed on the same layer of the semiconductor device 500. The emitter region 518 for common emitter stage 162 and collector region 514' for the common base stage 164 are formed on the same layer of the semiconductor device 500.

The semiconductor device 500 has three metal layers respectively 552, 554, and 556 which are separated by layers containing dielectric material 526. Vias 558 are used to connect between the different metal layers and to connect the first metal layer 552 to the contacts 522,524 of the common emitter transistor 162 and contacts 520, 522' of the common emitter transistor 164.

Turning now to figure 7B, the ground rail 154 is connected by the third layer metal 556 to the emitter contact 524 via contacts 560 down through the second metal layer 554 and the first metal layer 552. Contacts 562 illustrate either contacts between the second metal layer 554 and the first metal layer 552 or the first metal layer 554 and the active area contacts. The common emitter transistor 162 of semiconductor device 500 as illustrated shows a single emitter finger. In other examples common emitter stages may have transistors with more emitter fingers. The transistors may be implemented in sections containing one or more emitter finger. The common base transistor 164 of semiconductor device 500 as illustrated is implemented in two sections 164_1, 164_2 each section having one emitter finger.

The RF input 158 connects to the base of the common emitter transistor 162. RF output 166 as shown is implemented on the third metal layer 556 and connects to the collector contact 520 of the common base transistor 164 using vias 558 down through the second metal layer 554 and the first metal layer 552. The inter-stage connection 160 is effectively formed in the common region of the buried-N layer 510.

The Semiconductor device 500 has a common emitter stage 162 with a single common emitter section a common base stage 164 with two common base sections 164_1, 164_2 on top of the same shared buried-N layer 510. In other examples the common emitter stage may have multiple sections alternating with multiple common base sections depending on the size of the device required. The ratio between CE transistor 162 and CB transistor size 164 may be modified by different section sizes for both, by modifying the number of emitter-fingers per section, as well as varying the length of the emitter-fingers independently for the CE transistor 162 and the CB transistor 164.

This semiconductor device 500 may have a smaller foot-print than semiconductor device 250 requiring reduced silicon area to implement. The semiconductor device 500 may have reduced inter-stage loss, due to reduced connection resistance because no metal interconnect is required and no contact/Deep-N plug is required. The semiconductor device 500 may further have reduced parasitic substrate capacitance. The semiconductor device 500 has a common base transistor 164 with a collector region 514' that extends laterally beyond the base. This may result in a higher breakdown voltage for the collector-base junction of the common base transistor 164 as explained in US9240468 B2 which may allow the semiconductor device 500 to operate at higher power. In other embodiments the semiconductor device may include a gate formed on the collector 514' of the common base transistor to modulate the electric field instead or as well as a collector 514' laterally extending beyond the base. This may further improve the breakdown voltage characteristics of the collector-base junction of the common-base transistor 164.

A semiconductor device is described including a substrate and a plurality of layers. The semiconductor device includes a cascode arrangement of a first bipolar transistor and a second bipolar transistor. A first-bipolar-transistor-collector of the first bipolar transistor and a second-bipolar-transistor-emitter of the second bipolar transistor are at least partially located in a common region in the same layer of the semiconductor device.

Embodiments of a semiconductor device include an integrated cascode (CE-CB-stage) device. The collector of the common-emitter transistor and the emitter of the common-base transistor are formed in a common region. Consequently, the collector of the common-emitter transistor device also acts as the emitter of the common-base transistor device, which eliminates the need for inter-stage matching and may reduce the device area. As a result, the overall losses due to parasitic resistances and/or capacitances may be significantly reduced, improving the RF performance of an amplifier including the integrated cascode. Embodiments of the cascode semiconductor device may use the same layers for forming both the common-base stage and common emitter stage and so are suitable for inclusion on an integrated circuit. The common base transistor and common emitter transistor may be vertical HBTs formed side-by-side. Because both CE and CB stages are in contact with the substrate, the thermal performance may be improved. The illustrated embodiments show NPN bipolar transistors implementing a cascode of a common emitter stage and a common base stage for an RF amplifier. In other embodiments a cascode of two NPN transistors may be used for other applications. It will be further appreciated from the present disclosure that other embodiments of a cascode may be implemented using PNP bipolar transistors.

Embodiments of the integrated cascode may be included in RF power amplifier or RF low noise amplifiers. Embodiments may be included in RF amplifiers operating at frequencies may above 20 GHz which are used for example in 5G mobile communications applications.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**TABLE OF REFERENCE SIGNS**

| Ref | Description |
|---|---|
| 100 | Typical Low Noise RF Amplifier |
| 102 | First stage supply |
| 102' | Second stage supply |
| 104 | Ground |
| 106 | RF output |
| 108 | RF input |
| Q1 | Common emitter transistor |
| Q2 | Common base transistor |
| Q3 | Second stage transistor |
| Lin | Input inductor |
| Lt | Tank inductor |
| Ct | Tank capacitor |
| Lo1 | First stage output inductor |
| Lmid | Inter-stage matching inductor |
| Ldeg | Q1 emitter degeneration inductor |
| Ldeg2 | Q3 emitter degeneration inductor |
| C11 | First stage matching capacitor |
| C12 | Capacitor |
| L11 | First stage matching inductor |
| Lo2 | Second stage output inductor |
| L21 | Second stage matching network inductor |
| C21 | Second stage matching network capacitor |
| C22 | Second stage matching network capacitor |
| 110 | Cascode Input Stage |
| 112 | Common node |
| Q1 | Common Emitter Transistor |
| Q2 | Common Base Transistor |
| 150 | Cascode for a RF amplifier |
| 154 | Ground |
| 156 | Common-base bias input |
| 158 | RF input |
| 160 | Inter-stage connection |
| 162 | Common Emitter (CE) Stage |
| 164 | Common base (CB) stage |
| 164_1 | First section of common base stage |
| 164_2 | Second section of common base stage |
| 166 | RF output |
| 200 | Typical NPN HBT Silicon-Germanium Transistor for RF applications |
| 202 | Substrate |
| 204, 204' | Trench |
| 206, 206' | P-well stopper |
| 208, 208' | Deep-N plug region |
| 210,210' | Buried n well |
| 212,212' | Epitaxial n-type region |
| 214,214' | N+ collector region |
| 216,216' | Silicon germanium base layer - intrinsic and extrinsic |
| 218,218' | N+ emitter region |
| 220,220' | Collector contacts |
| 222,222' | Base contacts |
| 224,224' | Emitter contacts |
| 226 | Dielectric regions |
| 250 | Typical cascode semiconductor device |
| 252 | First metal layer |
| 254 | Second metal layer |
| 256 | Third metal layer |
| 258 | Vias |
| 260 | Third metal layer contacts |
| 262 | Contacts |
| 300 | Cascode semiconductor device according to an embodiment |
| 302 | Substrate |
| 304 | Trench |
| 306 | P-well stopper |
| 310 | Buried n well |
| 312 | Epitaxial n-type region |
| 314,314' | N+ collector region |
| 316,316' | Silicon germanium base layer - intrinsic and extrinsic |
| 318,318' | N+ emitter region |
| 320 | Collector contacts |
| 322,322' | Base contacts |
| 324 | Emitter contacts |
| 326 | Dielectric regions |
| 352 | First metal layer |
| 354 | Second metal layer |
| 356 | Third metal layer |
| 358 | Vias |
| 360 | Third metal layer contacts |
| 362 | Contacts |
| 400 | Cascode semiconductor device according to an embodiment |
| 402 | Substrate |
| 404 | Trench |
| 406 | P-well stopper |
| 410 | Buried n well |
| 412 | Epitaxial n-type region |
| 414,414' | N+ region |
| 416,416' | Silicon germanium base layer - intrinsic and extrinsic |
| 418,418' | N+ emitter region |
| 420 | Collector contacts |
| 422,422' | Base contacts |
| 424,424' | Emitter contacts |
| 426 | Dielectric regions |
| 452 | First metal layer |
| 454 | Second metal layer |
| 456 | Third metal layer |
| 458 | Vias |
| 460 | Third metal layer contacts |
| 462 | Contacts |
| 500 | Cascode semiconductor device according to an embodiment |
| 502 | Substrate |
| 504, 504' | Trench |
| 506, 506' | P-well stopper |
| 508, 508' | Deep-N plug region |
| 510,510' | Buried n well |
| 512,512' | Epitaxial n-type region |
| 514,514' | N+ collector region |
| 516,516' | Silicon germanium base layer - intrinsic and extrinsic |
| 518,518' | N+ emitter region |
| 520 | Collector contacts |
| 522,522' | Base contacts |
| 524,524' | Emitter contacts |
| 526 | Dielectric regions |
| 552 | First metal layer |
| 554 | Second metal layer |
| 556 | Third metal layer |
| 558 | Vias |
| 560 | Third metal layer contacts |
| 562 | Contacts |

## Claims

1. A semiconductor device comprising a substrate, a plurality of layers located on or in the substrate and a lateral cascode arrangement of a first bipolar transistor and a second bipolar transistor, wherein the first bipolar transistor comprises a first-bipolar-transistor-collector , the second bipolar transistor comprises a second-bipolar-transistor-emitter and wherein the first-bipolar-transistor-collector and the second-bipolar-transistor-emitter are at least partially located in a common region in one of said plurality of layers.

2. The semiconductor device of claim 1 wherein the first bipolar transistor further comprises a first-bipolar-transistor-base located above the first-bipolar-transistor-collector and a first-bipolar-transistor-emitter located above the first-bipolar-transistor-base and the second bipolar transistor comprises a second-bipolar-transistor-base located above the second-bipolar-transistor-emitter and a second-bipolar-transistor-collector located above the second-bipolar-transistor-base.

3. The semiconductor device of any preceding claim wherein the common region comprises a buried N type layer.

4. The semiconductor device of any preceding claim wherein the first and second bipolar transistors are NPN transistors.

5. The semiconductor device of any preceding claim wherein the common region is located between two trenches.

6. The semiconductor device of any preceding claim comprising a common emitter stage comprising the first bipolar transistor and a common base stage comprising the second bipolar transistor.

7. The semiconductor device of any preceding claim wherein the second-bipolar-transistor-collector includes a portion extending laterally past an edge of the base.

8. The semiconductor device of any preceding claim wherein the second-bipolar-transistor-collector comprises a collector gate.

9. The semiconductor device of any preceding claim wherein the first-bipolar-transistor-emitter and second-bipolar-transistor-emitter further comprise at least one emitter finger.

10. The semiconductor device of any preceding claim wherein the first bipolar transistor comprises at least one section located above the common region and the second bipolar transistor comprises at least two sections located above the common region and wherein the each section of the at least one first bipolar transistor section is arranged alternately with each section of the at least two second bipolar transistor sections.

11. The semiconductor device of any preceding claim further comprising an input coupled to the first-bipolar-transistor-base, an output coupled to the second-bipolar-transistor-collector, a supply rail coupled to the second-bipolar-transistor-collector, a ground rail coupled to the first-bipolar-transistor-emitter, and wherein the second-bipolar-transistor-base is coupled to a bias voltage rail.

12. The semiconductor device of any preceding claim wherein the first bipolar transistor base and the second bipolar transistor base are located in the same layer.

13. The semiconductor device of any preceding claim wherein the first-bipolar-transistor-emitter and the second-bipolar-transistor-collector are at least partially located in the same layer.

14. A silicon-germanium BiCMOS device comprising the semiconductor device of any preceding claim.

15. An RF amplifier comprising the semiconductor device of any of claims 1 to 13.
